# EUROPÄISCHE PATENTANMELDUNG

(11) **EP 2 590 238 A2**
(43) Veröffentlichungstag der Anmeldung: **08.05.2013**
(21) Anmeldenummer: 12187225.3
(22) Anmeldetag: 04.10.2012
(51) Int. Cl.: H01L 35/30

(54) **Vorrichtung, Verfahren zur Herstellung derselben sowie Verfahren zur Erzeugung elektrischer Energie durch einen Temperaturgradienten**

(30) Priorität: 07.11.2011 AT 16332011
(71) Anmelder: Hönigsberger, Oliver, 9570 Osslach (AT)
(72) Erfinder: Hönigsberger, Oliver, 9570 Osslach (AT)
(74) Vertreter: Wirnsberger, Gernot

(57) **Zusammenfassung**

Die Erfindung betrifft eine Vorrichtung (1) zur Erzeugung elektrischer Energie durch einen Temperaturgradienten, wobei die Vorrichtung (1) ein mit einer ersten Oberfläche (2) und einer zweiten Oberfläche (3) thermisch verbundenes Halbleiterelement, insbesondere ein Peltierelement, aufweist, wobei bei einer Temperaturdifferenz zwischen der ersten Oberfläche (2) und der zweiten Oberfläche (3) am Halbleiterelement eine elektrische Spannung entsteht. Erfindungsgemäß ist ein aus Grafit bestehendes Verbindungsteil (5) vorgesehen, welches die erste Oberfläche (2) mit dem Halbleiterelement und/oder die zweite Oberfläche (3) mit dem Halbleiterelement thermisch verbindet.

Weiter betrifft die Erfindung ein Verfahren zur Herstellung einer Vorrichtung (1) zur Erzeugung elektrischer Energie durch einen Temperaturgradienten.

Darüber hinaus betrifft die Erfindung ein Verfahren zur Erzeugung elektrischer Energie durch einen Temperaturgradienten.

## Beschreibung

Die Erfindung betrifft eine Vorrichtung zur Erzeugung elektrischer Energie durch einen Temperaturgradienten, wobei die Vorrichtung ein mit einer ersten Oberfläche und einer zweiten Oberfläche thermisch verbundenes Thermoelement, insbesondere ein Peltierelement, aufweist, wobei bei einer Temperaturdifferenz zwischen der ersten Oberfläche und der zweiten Oberfläche am Thermoelement eine elektrische Spannung entsteht.

Weiter betrifft die Erfindung ein Verfahren zur Herstellung einer Vorrichtung zur Erzeugung elektrischer Energie durch einen Temperaturgradienten, wobei ein Thermoelement, insbesondere ein Peltierelement, mit einer ersten Oberfläche und einer zweiten Oberfläche thermisch verbunden wird, wobei bei einer Temperaturdifferenz zwischen der ersten Oberfläche und der zweiten Oberfläche am Thermoelement eine elektrische Spannung entsteht.

Darüber hinaus betrifft die Erfindung ein Verfahren zur Erzeugung elektrischer Energie durch einen Temperaturgradienten mit einer Vorrichtung, welche ein mit einer ersten Oberfläche und einer zweiten Oberfläche thermisch verbundenes Thermoelement aufweist, wobei aufgrund einer Temperaturdifferenz eine Wärmemenge von der ersten Oberfläche durch das Thermoelement zur zweiten Oberfläche übertragen wird, wodurch eine elektrische Spannung am Thermoelement hervorgerufen wird.

Aus dem Stand der Technik sind Vorrichtungen der eingangs genannten Art bekannt, wobei aufgrund einer Thermoelektrizität in einem Stromkreis bei einer Temperaturdifferenz zwischen Kontaktstellen eine elektrische Spannung entsteht, welche auch als Seebeckspannung bezeichnet wird. Weiter ist es aus dem Stand der Technik auch bekannt, eine entsprechende Vorrichtung in einer Solaranlage einzusetzen, um eine Temperaturdifferenz zwischen Teilen der Solaranlage und einer Umgebung in elektrische Energie umzuwandeln. Dabei ist beispielsweise die erste Oberfläche mit einem Heißwasser führenden Rohr verbunden und die zweite Oberfläche luftgekühlt ausgeführt. Ein Wärmestrom erfolgt dann aufgrund der Temperaturdifferenz von der ersten Oberfläche durch das Thermoelement zur zweiten Oberfläche, wobei elektrische Energie erzeugt wird. Nachteilig bei derartigen Vorrichtungen des Standes der Technik ist, dass eine Wärme von einem heißen Medium, beispielsweise Wasser in einer Solaranlage, an das Thermoelement nur mit hohen Verlusten übertragbar ist und Wärmeübergangswiderstände an Grenzflächen sowie zwischen der ersten Oberfläche, dem Thermoelement und der zweiten Oberfläche hoch sind. Darüber hinaus ist eine Verbindung eines Thermoelementes mit Körpern, welche ein Medium führen, wie beispielsweise Rohre, gemäß den Vorrichtungen des Standes der Technik sehr aufwendig und teuer in einer Herstellung.

Aufgabe der Erfindung ist es daher, eine Vorrichtung der eingangs genannten Art anzugeben, welche eine Wärmeübertragung mit geringeren Verlusten erlaubt sowie einfach und kostengünstig herstellbar ist.

Darüber hinaus soll ein Verfahren der eingangs genannten Art zur Herstellung einer derartigen Vorrichtung angegeben werden, um eine Vorrichtung mit besonders hohem Wirkungsgrad herzustellen.

Weiter soll ein Verfahren der eingangs genannten Art zur Erzeugung elektrischer Energie durch einen Temperaturgradienten angegeben werden, mit welchem elektrische Energie besonders effizient erzeugt werden kann.

Die erste Aufgabe wird erfindungsgemäß dadurch gelöst, dass bei einer Vorrichtung der eingangs genannten Art zumindest ein Grafit umfassendes Verbindungsteil vorgesehen ist, welches die erste Oberfläche mit dem Thermoelement und/oder die zweite Oberfläche mit dem Thermoelement thermisch verbindet. Besonders günstig ist es, wenn das Verbindungsteil aus Grafit besteht. Dadurch ergibt sich eine besonders gute Wärmeleitung zwischen der jeweiligen Oberfläche und dem Thermoelement, welches vorzugsweise als Halbleiterelement, insbesondere als Peltierelement, ausgeführt ist. Dies führt zu einer erhöhten Effizienz eines mit der Vorrichtung ausgeführten Verfahrens sowie zu einer verbesserten Kühlung des Mediums, welches Wärme an die erste Oberfläche abgibt.

Bevorzugt sind Basalebenen des Grafits entlang einer Normalen zu den beiden Oberflächen ausgerichtet. Basalebenen werden auch als Schichten mit einer sp²-Hybridisierung bezeichnet und sind durch drei sp²-Orbitale von Kohlenstoffatomen charakterisiert, welche symmetrisch in einer Ebene liegen und senkrecht zu einem p-Orbital von Kohlenstoffatomen angeordnet sind. Grafit weist anisotrope Wärmeleitungseigenschaften auf, wobei entlang dieser Basalebenen im Grafit eine Wärmeleitung günstig ist und in Richtungen orthogonal zu diesen Basalebenen Wärmeübergangswiderstände hoch sind. Durch die entlang einer direkten Verbindungslinie zwischen den beiden Oberflächen bzw. zwischen einer Oberfläche und dem Thermoelement ausgerichteten Basalebenen ergibt sich ein besonders geringer Wärmewiderstand zwischen den Oberflächen bzw. zwischen einer Oberfläche und dem Thermoelement. Darüber hinaus ist ein Wärmewiderstand in Richtungen normal auf diese Verbindungslinie hoch, weswegen nur eine geringe Wärmemenge an eine Umgebung abgegeben wird. Dies führt zu einer weiter erhöhten Effizienz der Vorrichtung.

Besonders bevorzugt ist vorgesehen, dass das Verbindungsteil aus expandiertem Grafit und/oder aus gepresstem Grafit besteht. Um expandierten Grafit herzustellen, wird herkömmlicher Grafit mit Fremdmolekülen oder -atomen interkaliert, wobei Moleküle bzw. Ionen zwischen Schichten des Grafits eingelagert werden. Dadurch ist ein gezieltes Beeinflussen physikalischer Parameter möglich. Auch ist es bekannt, Grafit durch Erhöhen einer Temperatur innerhalb sehr kurzer Zeit zu expandieren. Wenn der, vorzugsweise expandierte, Grafit mittels Pressen an ein Bauteil angeformt wird, ergibt sich eine besonders gute Verbindung mit geringem Wärmeübergangswiderstand.

Auch ein Einsatz von Grafitschaum als Material des Verbindungsteiles hat sich als günstig erwiesen, um eine hohe Elastizität des Verbindungsteiles zu erzielen. Selbstverständlich ist alternativ oder ergänzend auch ein Einbringen von festen Bestandteilen möglich, beispielsweise um Festigkeits- oder Steifigkeitseigenschaften des Grafits zu beeinflussen. Vorteil des Grafitschaumes ist, dass eine Steifigkeit verglichen mit nicht geschäumtem Grafit wesentlich geringer ist, wodurch der Grafit besonders gut formbar ist. Ein zu Schaum aufgequellter Grafit ist ähnlich elastisch wie Polystyrolschaumstoff, sodass es auch möglich ist, Gegenstände, wie beispielsweise Rohre, einfach in den Grafit einzupressen. Insbesondere sind dann auch unterschiedliche Wärmeausdehnungskoeffizienten eines eingepressten Gegenstandes und des Grafits unproblematisch, da Grafitschaum eine geringe Steifigkeit aufweist. Dadurch kann eine Wärme übertragende Oberfläche besonders gut an ein Bauteil, insbesondere an ein Rohr, angeformt werden.

Alternativ kann auch sogenannter synthetischer Grafit eingesetzt werden, welcher als Pressling vorgefertigt wird und beispielsweise durch Fräsen in eine beliebige Form gebracht werden kann, um an einen Wärme führenden Gegenstand besonders gut angeformt werden zu können. Eine Anpassung eines Wärmeausdehnungskoeffizienten des Grafits an einen Wärmeausdehnungskoeffizienten des Gegenstandes, insbesondere Rohres, welches ein heißes Medium führt, kann beispielsweise durch eine Abstimmung einer Grafitmischung oder durch Rohre bestehend aus besonderen Materialien, insbesondere Metallen mit ähnlichem Wärmeausdehnungskoeffizient wie Grafit, erfolgen. Dadurch werden Wärmespannungen bei einem Betrieb der Vorrichtung aufgrund unterschiedlicher Wärmeausdehnungen verhindert oder zumindest minimiert.

Zweckmäßigerweise sind das Thermoelement und/oder Leitungen und/oder Isolatoren auf das Verbindungsteil aufgesintert. Wenn das Thermoelement, welches vorzugsweise als Halbleiterelement ausgeführt ist, insbesondere als Peltierelement, durch Sintern auf dem Verbindungsteil hergestellt wird, ergibt sich aufgrund einer innigen Verbindung ein besonders geringer Wärmeübergangswiderstand zwischen dem Verbindungsteil und dem Halbleiterelement. Dabei können einzelne Schichten des Halbleiterelementes, wie PN-Übergänge und Leitungsbahnen durch Sintern auf dem Verbindungsteil hergestellt werden, wodurch eine Herstellung vereinfacht und Effizienz erhöht wird. Auch ein Aufsintern von Isolatoren, welche für eine Funktion des Peltierelementes erforderlich sind, ist möglich. Besonders Keramik hat sich in diesem Zusammenhang als Isolatormaterial bewährt, da dieses Material isoliert und gut sinterbar ist.

Mit Vorteil ist die erste Oberfläche mit einem Rohr, insbesondere einem Wellrohr, verbunden. Dadurch kann eine Wärme eines im Rohr transporierten Mediums, beispielsweise Wasser bei einer Solaranlage, besonders gut zur Erzeugung elektrischer Energie genutzt werden. Ein Wellrohr hat darüber hinaus den Vorteil, dass eine Wärmeübertragungsfläche zwischen Rohr und Vorrichtung vergrößert ist, wodurch Wärme besonders gut übertragbar ist. Vorzugsweise wird die erste Oberfläche, welche Teil des Verbindungsteiles aus Grafit ist, an das Wellrohr angepresst, wobei im Verbindungsteil eine negative Außenktonur des Wellrohres durch Pressen gebildet wird. Alternativ kann vorgesehen sein, dass in das Verbindungsteil vor einer Montage eine Negativkontur des Rohres, an welches das Verbindungsteil angebracht wird, eingebracht wird, um eine vollflächige Verbindung zwischen Verbindungsteil und Rohr zu erzielen.

Besonders günstig ist es, wenn die zweite Oberfläche mit einer Wärmesenke, insbesondere einem Kühlkörper, verbunden ist, um einen großen Wärmestrom zu erzielen. Der Kühlkörper kann auch als Wärmespeicher, insbesondere als Wasserspeicher, ausgeführt sein, um ein späteres Verwenden der Wärme, beispielsweise zu Heizzwecken, zu ermöglichen. Alternativ kann der Kühlkörper einfach als Kupferplatte ausgeführt sein. Eine bevorzugte Ausführung der Vorrichtung sieht vor, dass ein Heißwasser führendes Rohr geteilt und zwei Teile des Rohres mittels Kupferplatten wieder verbunden sind, sodass aufgrund der Kupferplatten eine große Wärmeübertragungsfläche entsteht, um Wärme durch die Vorrichtung an eine Umgebung zu übertragen, wobei elektrische Energie erzeugt wird. Die erfindungsgemäße Vorrichtung wird dabei vorzugsweise an Positionen eingesetzt, an welchen ein Temperaturgradient besonders hoch ist. Es kann jedoch auch vorgesehen sein, dass die Teile des Rohres durch Grafitelemente einer erfindungsgemäßen Vorrichtung verbunden sind, sodass die Wärme des Heißwassers direkt an die Vorrichtung übertragen wird, von welcher diese durch die zweite Oberfläche an die Umgebung abgegeben wird. An der zweiten Oberfläche der Vorrichtung sind bei einer derartigen Ausführung vorzugsweise Kühlrippen vorgesehen, welche beispielsweise aus Aluminium oder Kupfer bestehen.

Bevorzugt ist das Rohr mit einer Solaranlage, insbesondere mit Vakuumröhren einer Solaranlage, verbunden. Dadurch kann eine Effizienz der Solaranlage weiter erhöht werden, da sonst ungenutzte Wärme zur Erzeugung elektrischer Energie eingesetzt werden kann.

Zweckmäßigerweise ist eine Steuerung mit der Solaranlage verbunden, mit welcher bei Betrieb der Solaranlage ein Temperaturgradient zwischen der ersten Oberfläche und der zweiten Oberfläche einstellbar ist. Dadurch wird eine Solaranlage gebildet, welche erst ab einem definierten Temperaturzustand, beispielsweise einer verfügbaren Überwärme, Überwärme zur Erzeugung elektrischer Energie nutzt. Durch einen Abbau einer Übertemperatur durch das Thermoelement wird auch eine Lebensdauer der Solaranlage, insbesondere bei einem Einsatz von Vakuumröhren, erzielt. Eine Steuerung kann beispielsweise durch eine mit der Solaranlage verbundene Datenschnittstelle erfolgen, welche relevante Daten der Solaranlage misst und bei Überschreiten eines Grenzwertes eine Pumpe oder Ventile aktiviert, sodass Wärme durch die erfindungsgemäße Vorrichtung in elektrische Energie gewandelt wird. Günstig ist es, wenn dazu eine thermische Überlastsicherung mit Sensoren vorgesehen ist, um eine Beschädigung der Vorrichtung aufgrund zu hoher Temperaturen zu verhindern. Selbstverständlich kann die Steuerung auch beispielsweise mittels TCP/IP-Protokoll an ein Netzwerk gekoppelt sein, um bei Bedarf Warnungen und Fehlermeldungen an einen Zentralrechner zu übertragen sowie eine Online-Fehlerdiagnose durchführen zu können.

Weiter hat es sich bewährt, dass die erste Oberfläche mit einer Geothermieanlage verbunden ist. Dadurch kann auch aus bei Geothermieanlagen auftretenden Temperaturunterschieden elektrische Energie gewonnen werden. Im Gegensatz zu Solaranlagen ist hierbei jedoch keine Lebenszeitverlängerung der Bauteile erzielbar. Diese wird insbesondere bei Solaranlagen durch Einsatz der Vorrichtung erzielt, da ein Cracken einer Frostschutzflüssigkeit durch Temperaturbeeinflussung vermindert wird, wodurch ein Belag auf Kupferrohren reduziert wird, welcher zu einer verschlechterten Wärmeleitung in der Solaranlage führt.

Darüber hinaus ist ein günstiger Einsatz der Vorrichtung möglich, wenn die erste Oberfläche mit einer Fotovoltaikanlage verbunden ist. Dabei hat es sich besonders bewährt, wenn die erste Oberfläche mit einer Rückseite bzw. einer einer Sonneneinstrahlung abgewandten Seite einer Fotovoltaikanlage verbunden ist, um die Fotovoltaikanlage flächig zu kühlen. Die zweite Oberfläche kann dabei mit einem Rohr, insbesondere einem Wellrohr, verbunden sein, welches ein Kühlmedium führt, beispielsweise Wasser. Günstigerweise wird das Rohr durch Einpressen mit einem aus Grafit bestehenden Verbindungsteil verbunden, welches die zweite Oberfläche bildet. Eine besonders gute Wirkung wird weiter erzielt, wenn eine Seite des Rohres, welche nicht mit der Vorrichtung verbunden ist, durch ein Dämmelement, beispielsweise Glasschaum, isoliert wird. Dadurch wird einerseits unerwünschter Wärmeaustausch mit einer Umgebung verhindert. Andererseits ergibt sich aufgrund einer Nachgiebigkeit des Glasschaumes eine besonders bündige Einpassung des Rohres. Besonders für auf Dächern montierte bzw. in Dächer integrierte Fotovoltaikanlagen hat sich eine derartige Ausführung bewährt.

Eine Kühlung mittels der erfindungsgemäßen Vorrichtung wie vorstehend beschrieben ist auch für Polymerfotovoltaikmodule möglich, wobei beispielsweise Folien bestehend aus Ethylen-Tetrafluorethylen (ETFE) zum Schutz der Solarzellen eingesetzt werden können. Dabei wird die erste Oberfläche direkt mit einer Rückseite von Solarzellen verbunden.

Es kann auch vorgesehen sein, dass die erste Oberfläche mit einer transparenten Folie, beispielsweise bestehend aus ETFE, oder transparenten Folienschichten verbunden ist. Dadurch kann einfallendes Sonnenlicht direkt an der ersten Oberfläche absorbiert werden, um beispielsweise ein besonders effizientes Solarwärmemodul zu realisieren. Aufgrund einer Elastizität des Grafits weist eine derartige Bauform auch eine verbesserte Sicherheit gegen Hagelschäden auf. Bei dieser Ausführung kann zwischen der durchsichtigen Folie und der ersten Oberfläche insbesondere bei vertikaler Montage auch eine Vakuumdämmplatte vorgesehen sein, um eine Wirkungsweise der Solarwärmemodule zu optimieren.

Die weitere Aufgabe wird erfindungsgemäß dadurch gelöst, dass bei einem Verfahren der eingangs genannten Art zur Herstellung einer Vorrichtung die erste Oberfläche durch ein Grafit umfassendes Verbindungsteil mit dem Thermoelement und/oder die zweite Oberfläche durch ein Grafit umfassendes Verbindungsteil mit dem Thermoelement thermisch verbunden wird. Dadurch wird eine besonders einfache Herstellung erreicht, wobei ein Wärmeübergangswiderstand vom Verbindungsteil auf das Thermoelement besonders gering ist, welches vorzugsweise als Halbleiter, insbesondere als Peltierelement, ausgeführt ist. Günstig ist es, wenn das Verbindungsteil zur Gänze aus Grafit besteht.

Um eine Effizienz bei der Übertragung von Wärme zu maximieren, ist es von Vorteil, wenn Basalebenen des Grafits des Verbindungsteiles entlang einer Geraden zwischen der ersten Oberfläche und der zweiten Oberfläche ausgerichtet werden.

Eine besonders verlustarme Wärmeübertragung wird erzielt, wenn ein Verbindungsteil bestehend aus expandiertem Grafit eingesetzt wird. Wird ein Verbindungsteil aus einem Grafitschaum eingesetzt, ist ein Anformen des Verbindungsteiles durch Pressen beispielsweise an ein Rohr besonders günstig möglich.

Ein besonders geringer Wärmeübergangswiderstand wird erzielt, wenn das Verbindungsteil mit einem Rohr oder dergleichen durch Pressen verbunden wird.

Die dritte Aufgabe wird gelöst, wenn bei einem Verfahren der eingangs genannten Art die Wärmemenge zumindest teilweise von zumindest einem Grafit umfassenden Verbindungsteil von der ersten Oberfläche zum Thermoelement und/oder vom Thermoelement zur zweiten Oberfläche übertragen wird. Bei diesem Verfahren kann die Wärme besonders verlustarm übertragen werden, wodurch eine hohe Effizienz des Verfahrens erzielt wird. Günstig ist es, wenn das Verbindungsteil zur Gänze aus Grafit besteht, um Verluste zu minimieren.

Bevorzugt wird die Wärmemenge entlang von Basalebenen im Verbindungsteil übertragen, welche entlang einer Geraden zwischen der ersten Oberfläche und der zweiten Oberfläche ausgerichtet sind.

Günstig ist es, wenn die Wärmemenge von einem Rohr auf die erste Oberfläche übertragen wird und/oder die Wärmemenge von der zweiten Oberfläche an einen Kühlkörper übertragen wird, da bei dieser Ausführung des Verfahrens keine weiteren Wärmeleiter erforderlich sind, an welchen Verluste entstehen könnten.

Mit Vorteil ist eine Temperaturdifferenz zwischen der ersten Oberfläche und der zweiten Oberfläche mittels einer Steuerung änderbar. Insbesondere wenn das Verfahren bei einer Solaranlage eingesetzt wird, kann so je nach Betriebszustand der Solaranlage eine überschüssige Wärme zur Erzeugung elektrischer Energie eingesetzt werden, wobei die Solaranlage gekühlt wird. Dadurch erhöht sich auch eine Lebenszeit von Bauteilen der Solaranlage, insbesondere wenn Vakuumröhren eingesetzt werden.

Weitere Merkmale, Vorteile und Wirkungen der Erfindung ergeben sich anhand der nachfolgend dargestellten Ausführungsbeispiele. In den Zeichnungen, auf welche dabei Bezug genommen wird, zeigen:
Fig. 1 eine erfindungsgemäße Vorrichtung;
Fig. 2, 2a und 2b weitere erfindungsgemäße Vorrichtungen;
Fig. 3 einen Kühlkörper, an welchem die Vorrichtung einsetzbar ist;
Fig. 4 und 5 weitere Anwendungen einer erfindungsgemäßen Vorrichtung;
Fig. 6 und 7 eine erfindungsgemäße Vorrichtung in zwei Fertigungsschritten;
Fig. 8 und 9 eine Vorrichtung gemäß Fig. 7 in zwei Anwendungsvarianten.

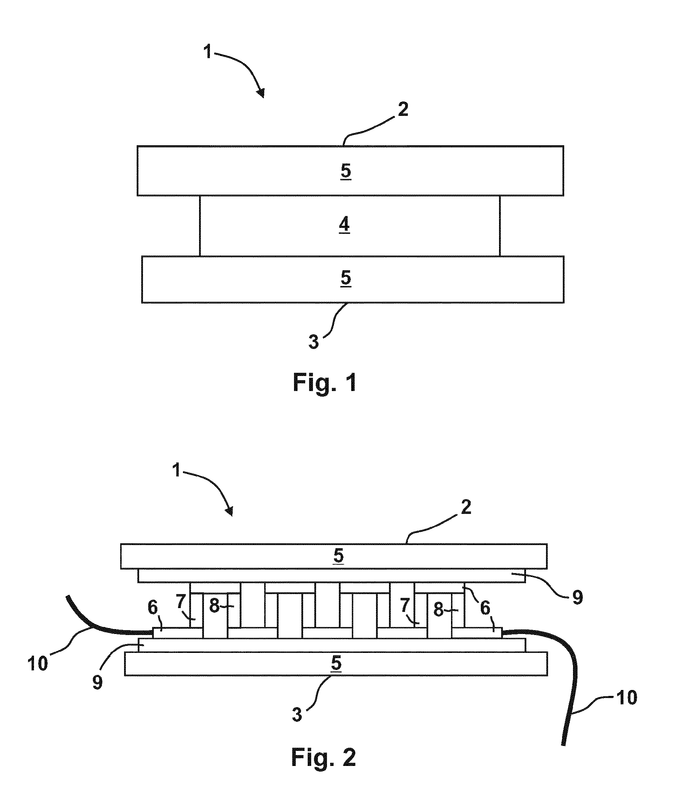

Fig. 1 zeigt eine erfindungsgemäße Vorrichtung 1 zur Erzeugung elektrischer Energie durch einen Temperaturgradienten. Ersichtlich ist, dass die Vorrichtung 1 eine erste Oberfläche 2 und eine zweite Oberfläche 3 aufweist, durch welche Wärme übertragbar ist. Zwischen den Oberflächen 2, 3 ist ein Thermoelement 4, vorzugsweise ein Halbleiterthermoelement, insbesondere ein Peltierelement, angeordnet, an welchem bei Anlegen einer Temperaturdifferenz zwischen der ersten Oberfläche 2 und der zweiten Oberfläche 3 eine elektrische Spannung anliegt. Wie ersichtlich sind zwischen der ersten Oberfläche 2 und dem Thermoelement 4 sowie zwischen der zweiten Oberfläche 3 und dem Thermoelement 4 jeweils Verbindungsteile 5 angeordnet. Diese bestehen erfindungsgemäß aus Grafit, wobei Basalebenen des Grafits vorzugsweise entlang einer direkten Verbindungslinie, insbesondere Normalen zu den Oberflächen, 2, 3, zwischen den Oberflächen 2, 3 bzw. zwischen den Oberflächen 2, 3 und dem Thermoelement 4 angeordnet sind. Vorteil dieser Ausführung ist, dass die Verbindungsteile 5 dadurch eine besonders hohe Wärmeleitfähigkeit in Richtung der Basalebenen im Grafit aufweisen und in einer Richtung orthogonal zu diesen Ebenen eine geringe Wärmeleitfähigkeit bzw. einen hohen Wärmewiderstand haben. Dadurch wird eine besonders gute Übertragung von Wärme zwischen der ersten Oberfläche 2 und dem Thermoelement 4 sowie zwischen der zweiten Oberfläche 3 und dem Thermoelement 4 gewährleistet, wobei eine Verlustwärme, welche an eine Umgebung abgegeben wird, minimiert ist. Die Oberflächen 2, 3 sind durch das oder die Verbindungsteile 5 gebildet.

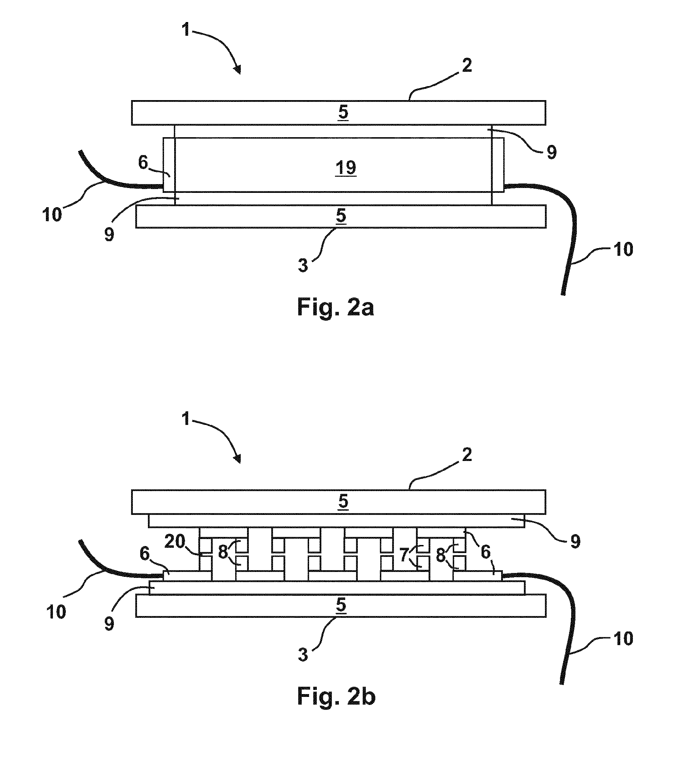

Fig. 2 zeigt schematisch eine weitere erfindungsgemäße Vorrichtung 1, wobei das Thermoelement 4 als Peltierelement ausgeführt ist. Bei dieser Ausführungsvariante wird eine besonders gute Wärmeübertragung zwischen dem Verbindungsteil 5 und dem Thermoelement 4 dadurch erzielt, dass das Thermoelement 4 durch Sintern auf dem Verbindungsteil 5 hergestellt ist. Dazu werden die einzelnen Elemente des Peltierelements, wie Isolatoren 9, Metallbrücken 6, n-Leiter 8 sowie p-Leiter 7 einzeln auf das Verbindungsteil 5 bestehend aus Grafit aufgesintert. Dabei bestehen die Isolatoren 9 vorzugsweise aus Keramik, da dieses Material besonders gut sinterbar ist. Dadurch wird einerseits eine besonders günstige Form der Herstellung erreicht. Andererseits ist ein Wärmeübergangswiderstand zwischen dem Thermoelement 4 und dem Verbindungsteil 5 dadurch minimiert. Besonders günstig ist es, wenn das Thermoelement 4 durch Sintern stoffschlüssig mit beiden Verbindungsteilen 5 verbunden ist. In Fig. 2 sind weiter auch Anschlüsse 10 dargestellt, an welchen elektrische Energie abnehmbar ist, sofern ein Temperaturgradient zwischen erster Oberfläche 2 und zweiter Oberfläche 3 besteht.

Fig. 2a zeigt eine weitere erfindungsgemäße Vorrichtung 1, wobei das Thermoelement 4 ein Silicid 19 umfasst, welches einen anisotropen Seebeck-Effekt hervorruft, beispielsweise ReSi_{1.75}. Selbstverständlich können auch weitere Materialien, welche einen anisotropen Seebeck-Effekt verursachen, eingesetzt werden. Bei derartigen Thermoelementen 4 ist eine Spannung, welche an den Anschlüssen 10 anliegt, bestimmt durch einen Unterschied zwischen einem longitudinalen und einem transversalen Seebeck-Effekt des Materials sowie einer anliegenden Temperaturdifferenz. Eine solche Ausführung des Thermoelementes 4 kann beispielsweise für besonders hohe Anforderungen hinsichtlich einer maximalen Einsatztemperatur der Vorrichtung 1 günstig sein.

Fig. 2b zeigt eine weitere erfindungsgemäße Vorrichtung 1, wobei das Thermoelement 4 derart ausgeführt ist, dass die n-Leiter 8 und die p-Leiter 7 jeweils durch einen Vakuumspalt 20 unterbrochen sind, welcher vorzugsweise weniger als 20 nm, insbesondere 5 nm bis 10 nm, groß ist. Der Vakuumspalt 20 bildet einerseits eine sehr gute thermische Isolierung. Andererseits ist aufgrund kleiner Spaltabmessungen ein Tunneln von Elektronen über den Vakuumspalt 20 möglich, sodass bei Anliegen eines Temperaturgradienten eine Spannung an den Anschlüssen 10 anliegt. Eine derartige Ausführung wird auch als Thermotunnel bezeichnet.

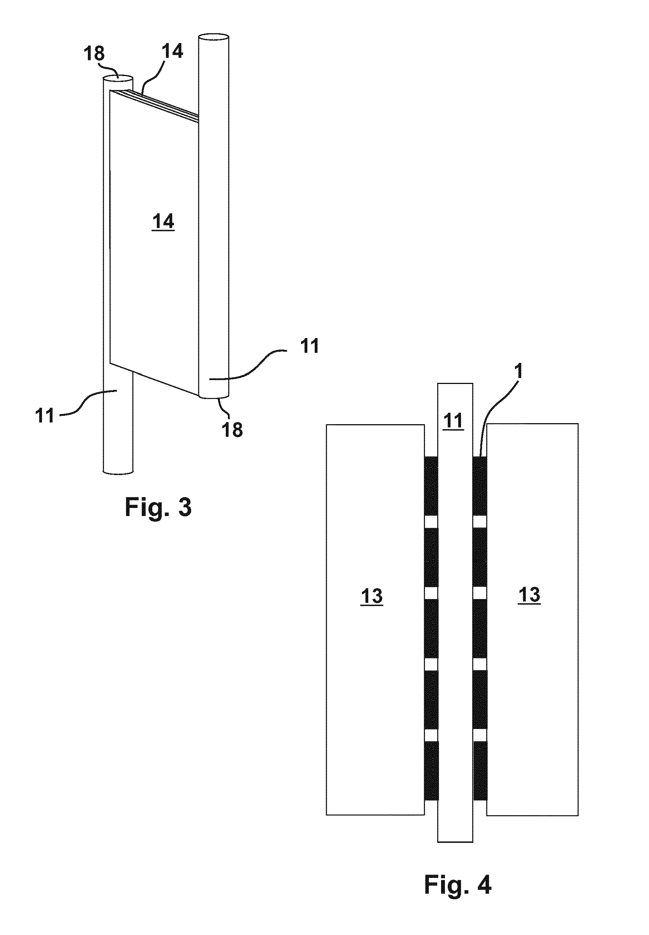

Fig. 3 zeigt einen Wärmetauscher, an welchem eine erfindungsgemäße Vorrichtung 1 beispielsweise angewendet werden kann. Ein Temperaturgradient zwischen der ersten Oberfläche 2 und der zweiten Oberfläche 3 wird bei dieser Ausführungsvariante dadurch erzielt, dass die in Fig. 3 nicht dargestellte Vorrichtung 1 mit Kupferplatten 14 verbunden wird, welche in einem geteilten, Heißwasser führenden Rohr 11, insbesondere Kupferrohr, angeordnet ist, wobei die Kupferplatten 14 vorzugsweise durch Kupferdrahtwellen beabstandet sind, wodurch auch eine gute Wärmeübertragung gewährleistet ist. Das Heißwasser tritt dann seitlich an einem Teil des geteilten Rohres 11 aus und fließt durch einen Hohlraum zwischen den Kupferplatten 14 bis zum zweiten Teil des geteilten Rohres 11, an welchem es seitlich in das Rohr 11 eintritt. Durch die Kupferplatten 14 ergibt sich eine Vergrößerung einer Wärmeübertragungsfläche, wodurch eine Wärme im Wasser besonders gut an eine Umgebung übertragen werden kann. Der Temperaturgradient ergibt sich aufgrund einer Temperaturdifferenz zwischen der Kupferplatte 14 und einer Umgebung. Werden erfindungsgemäße Vorrichtungen 1 auf den Kupferplatten 14 angeordnet, wobei die erste Oberfläche 2 mit der Kupferplatte 14 verbunden wird und die zweite Oberfläche 3 mit einer Umgebung in Kontakt steht, kann durch den Temperaturgradienten elektrische Energie erzeugt werden. Wie gemäß Fig. 3 ersichtlich wird diese Vorrichtung 1 besonders einfach gebildet, wenn Rohre 11 mit etwa parallelen Kupferplatten 14 verbunden werden, wobei jeweils die Rohrenden 18 der Rohre 11 verschlossen werden. Dadurch ist eine besonders einfache Herstellung möglich.

Fig. 4 zeigt eine weitere Anwendung einer erfindungsgemäßen Vorrichtung 1, wobei eine Wärme einer Flüssigkeit innerhalb eines Heißwasser führenden Rohres 11 zum Bilden eines Temperaturgradienten eingesetzt wird. Bei dieser Ausführungsvariante wird eine erfindungsgemäße Vorrichtung 1 mit der ersten Oberfläche 2 direkt mit dem Heißwasser führenden Rohr 11 verbunden. Um den Temperaturgradienten zu bilden, wird die zweite Oberfläche 3 mit einem Kühlkörper 13 verbunden, welcher im einfachsten Fall als Platte, vorzugsweise als Kupferplatte 14, ausgeführt sein kann. Wie in Fig. 4 dargestellt ist eine besonders effektive Erzeugung elektrischer Energie möglich, wenn das Heißwasser führende Rohr 11 an zwei Seiten mit erfindungsgemäßen Vorrichtungen 1 bestückt ist, welche jeweils mit Kühlkörpern 13 verbunden sind. Eine Wärme wird dann vom Heißwasser durch das Rohr 11 an das Verbindungsteil 5 und von diesem weiter an das Thermoelement 4 und den Kühlkörper 13 übertragen, von welchem die Wärme an ein Umgebungsmedium des Kühlkörpers 13 abgegeben wird.

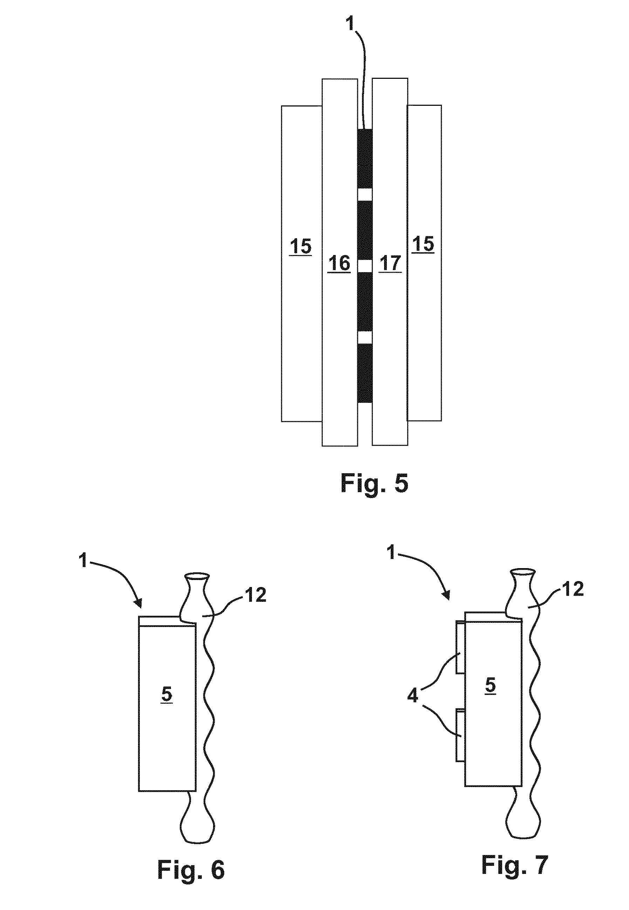

Fig. 5 zeigt eine weitere Anwendung einer erfindungsgemäßen Vorrichtung 1, wobei mehrere Vorrichtungen 1 zwischen einem Heißwasserrohr 16 und einem Kaltwasserrohr 17 angeordnet und mit diesen thermisch verbunden sind, wobei das Heißwasserrohr 16 und das Kaltwasserrohr 17 Wasser unterschiedlicher Temperaturen führen. Dazu werden die Vorrichtungen 1 mit der ersten Oberfläche 2 mit dem Heißwasserrohr 16 und mit der zweiten Oberfläche 3 mit dem Kaltwasserrohr 17 verbunden, wobei Verbindungsteile 5, welche das Thermoelement 4 mit den Oberflächen 2, 3 verbinden, vorzugsweise aus expandiertem, gepressten Grafit bestehen und wobei Basalebenen in Richtung einer direkten Verbindungslinie bzw. geraden zwischen den Rohren 11 ausgerichtet sind. Um ein Übertragen von Wärme an eine Umgebung und damit einen Wärmeverlust zu vermeiden, sind die Rohre 11 an Seiten thermisch mit einer Isolierung 15 versehen, an welchen keine Vorrichtungen 1 angeordnet sind. Wie ersichtlich können mehrere Vorrichtungen 1 zwischen dem Heißwasserrohr 16 und dem Kaltwasserrohr 17 angeordnet sein, um auch größere Wärmemengen zu transportieren und entsprechende Mengen an elektrischer Energie zu erzeugen. Eine Bewegungsrichtung von Flüssigkeiten, insbesondere Wasser, in dem Heißwasserrohr 16 und dem Kaltwasserrohr 17 kann dabei entsprechend einem Gleichstrom-Prinzip in gleicher Richtung orientiert oder entsprechend einem Wechselstrom-Prinzip in entgegengesetzten Richtungen orientiert vorgesehen sein.

Fig. 6 zeigt ein Wellrohr 12, an welches ein Verbindungsteil 5 einer erfindungsgemäßen Vorrichtung 1 angeformt ist. Das Verbindungsteil 5 kann dazu mit einer Negativform des Wellrohres 12 versehen sein, sodass sich eine vollflächige Kontaktfläche ergibt. Besonders günstig ist es jedoch, wenn expandierter Grafit eingesetzt wird, welcher eine reduzierte Festigkeit aufweist und besonders einfach an das Wellrohr 12 angepresst werden kann. Dadurch ergibt sich eine besonders gute Verbindungsfläche mit sehr geringem Wärmeübergangswiderstand. Ein Wellrohr 12 hat verglichen mit einem zylindrischen Rohr 11 insbesondere den Vorteil, dass eine Fläche für die Wärmeübertragung maximiert ist, durch welche Wärme übertragbar ist, sodass mit einer vergleichsweise geringen Länge eines Rohres 11 große Wärmemengen übertragbar sind. Insbesondere bei Einsatz der Vorrichtung 1 in einer Solaranlage hat sich ein Einsatz von Wellrohren 12 bewährt.

Fig. 7 zeigt eine Vorrichtung 1 gemäß Fig. 6 in einem weiteren Herstellungsschritt. Ersichtlich ist, dass in diesem Herstellungsschritt bereits Halbleiterelemente auf dem Verbindungsteil 5 angeordnet sind, welche vorzugsweise aufgesintert sind. Durch ein Aufsintern der Thermoelemente 4 bzw. Peltierelemente ergibt sich eine besonders gute Verbindung mit sehr geringem Wärmeübergangswiderstand.

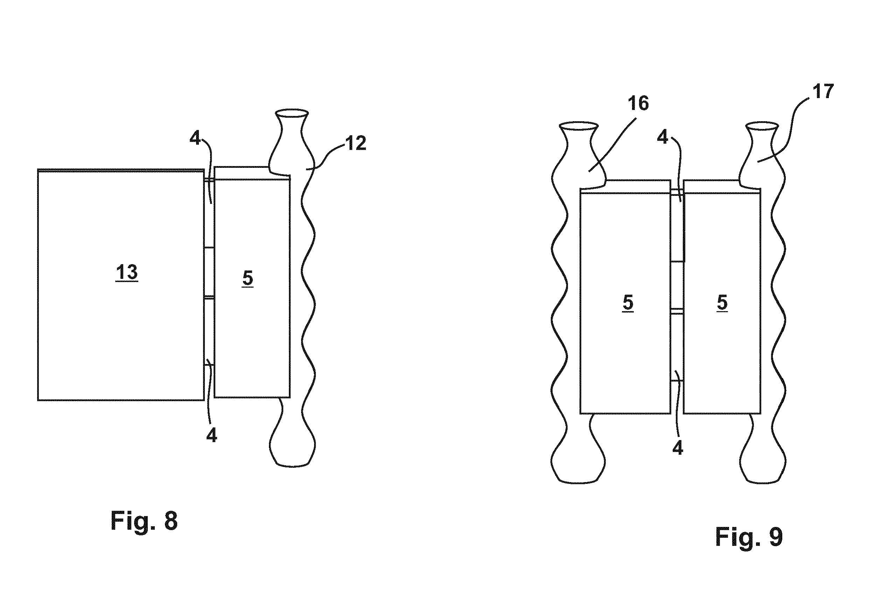

Fig. 8 zeigt eine Anwendung eines Wellrohres 12 mit einer erfindungsgemäßen Vorrichtung 1 gemäß Fig. 7, wobei ein Kühlkörper 13 mit den Thermoelementen 4 verbunden ist, um den Temperaturgradienten zu bilden. Der Kühlkörper 13 kann eine einfache Platte oder alternativ ein Körper mit mehreren Kühlrippen sein, welcher von einem Fluid, insbesondere Luft oder Wasser umströmt ist, um Wärme abzugeben. Dadurch kann Wärme einer Flüssigkeit des Wellrohres 12 besonders effektiv zur Erzeugung elektrischer Energie genutzt werden. Bei dieser Ausführungsvariante ist lediglich die erste Oberfläche 2 durch ein aus Grafit bestehendes Verbindungsteil 5 mit dem Thermoelement 4 verbunden, während die zweite Oberfläche 3 durch den Kühlkörper 13 gebildet wird und direkt mit dem Thermoelement 4 verbunden ist. Alternativ kann selbstverständlich auch zwischen dem Kühlkörper 13 und dem Thermoelement 4, welches vorzugsweise als Peltierelement ausgeführt ist, ein Verbindungsteil 5 aus Grafit vorgesehen sein.

Fig. 9 zeigt eine weitere Anwendung einer erfindungsgemäßen Vorrichtung 1, wobei die Temperaturdifferenz zwischen einem Heißwasserrohr 16 und einem Kaltwasserrohr 17 genutzt wird. Gemäß diesem Ausführungsbeispiel sind Heißwasserrohr 16 und Kaltwasserrohr 17 als Wellrohre 12 ausgeführt. Wie dargestellt ist mit dem Heißwasserrohr 16 und mit dem Kaltwasserrohr 17 jeweils ein Verbindungsteil 5 bestehend aus Grafit verbunden, um einen besonders guten Wärmeübergang zu gewährleisten. Die Verbindungsteile 5 sind mit einem zwischen den Verbindungsteilen 5 angeordneten Thermoelement 4, vorzugsweise einem Peltierelement, verbunden, um durch einen Temperaturgradienten zwischen Heißwasserrohr 16 und Kaltwasserrohr 17 elektrische Energie zu erzeugen.

Mit einer erfindungsgemäßen Vorrichtung 1 können Temperaturgradienten, welche sich beispielsweise in Solaranlagen ergeben, besonders gut genutzt werden. Ein Wärmeübergangswiderstand wird aufgrund einer optimalen Anformbarkeit des Grafits an verschiedene Formen wärmeführender Teile minimiert. Aufgrund einer Ausrichtung des Grafits mit Basalebenen entlang einer direkten Verbindung zwischen den Oberflächen 2, 3 bzw. entlang einer direkten Verbindung zwischen den Oberflächen 2, 3 und dem Thermoelement 4 ergibt sich auch ein besonders geringer Wärmewiderstand im Verbindungsteil 5. Insbesondere bei einem Einsatz der Vorrichtung 1 in einer Solaranlage können damit Vorteile erzielt werden. Einerseits ist es möglich, eine überschüssige Wärme zur Erzeugung elektrischer Energie zu nutzen. Andererseits können Bauteile gekühlt werden, um deren Lebensdauer zu verlängern. Durch eine zusätzliche Steuerung in der Solaranlage, welche eine Überwärme zur Erzeugung elektrischer Energie durch eine erfindungsgemäße Vorrichtung 1 nutzt, kann eine Effizienz von Solaranlagen deutlich verbessert werden.

## Patentansprüche

1. Vorrichtung (1) zur Erzeugung elektrischer Energie durch einen Temperaturgradienten, wobei ein mit einer ersten Oberfläche (2) und einer zweiten Oberfläche (3) thermisch verbundenes Thermoelement (4), insbesondere ein Peltierelement, vorgesehen ist, wobei bei einer Temperaturdifferenz zwischen der ersten Oberfläche (2) und der zweiten Oberfläche (3) am Thermoelement (4) eine elektrische Spannung entsteht, **dadurch gekennzeichnet, dass** zumindest ein Grafit umfassendes Verbindungsteil (5) vorgesehen ist, welches die erste Oberfläche (2) mit dem Thermoelement (4) und/oder die zweite Oberfläche (3) mit dem Thermoelement (4) thermisch verbindet.

2. Vorrichtung (1) nach Anspruch 1, **dadurch gekennzeichnet, dass** Basalebenen des Grafits entlang einer Normalen zu den beiden Oberflächen (2, 3) ausgerichtet sind.

3. Vorrichtung (1) nach Anspruch 1 oder 2, **dadurch gekennzeichnet, dass** das Verbindungsteil (5) aus expandiertem Grafit und/oder aus gepresstem Grafit besteht.

4. Vorrichtung (1) nach einem der Ansprüche 1 bis 3, **dadurch gekennzeichnet, dass** das Thermoelement (4) und/oder Leitungen und/oder Isolatoren (9) auf das Verbindungsteil (5) aufgesintert sind.

5. Vorrichtung (1) nach einem der Ansprüche 1 bis 4, **dadurch gekennzeichnet, dass** die erste Oberfläche (2) mit einem Rohr (11), insbesondere einem Wellrohr (12), verbunden ist.

6. Vorrichtung (1) nach Anspruch 5, **dadurch gekennzeichnet, dass** das Rohr (11) mit einer Solaranlage, insbesondere mit Vakuumröhren einer Solaranlage, verbunden ist.

7. Vorrichtung (1) nach Anspruch 6, **dadurch gekennzeichnet, dass** eine Steuerung mit der Solaranlage verbunden ist, mit welcher bei Betrieb der Solaranlage ein Temperaturgradient zwischen der ersten Oberfläche (2) und der zweiten Oberfläche (3) einstellbar ist.

8. Vorrichtung nach einem der Ansprüche 1 bis 4, **dadurch gekennzeichnet, dass** die erste Oberfläche (2) mit einer transparenten Folie, beispielsweise bestehend aus ETFE, oder transparenten Folienschichten verbunden ist.

9. Vorrichtung nach einem der Ansprüche 1 bis 4, **dadurch gekennzeichnet, dass** die erste Oberfläche (2) mit einer Fotovoltaikanlage verbunden ist.

10. Verfahren zur Herstellung einer Vorrichtung (1) zur Erzeugung elektrischer Energie durch einen Temperaturgradienten, insbesondere einer Vorrichtung (1) nach einem der Ansprüche 1 bis 9, wobei ein Thermoelement (4), insbesondere ein Peltierelement, mit einer ersten Oberfläche (2) und einer zweiten Oberfläche (3) thermisch verbunden wird, wobei bei einer Temperaturdifferenz zwischen der ersten Oberfläche (2) und der zweiten Oberfläche (3) am Thermoelement (4) eine elektrische Spannung entsteht, **dadurch gekennzeichnet, dass** die erste Oberfläche (2) durch ein Grafit umfassendes Verbindungsteil (5) mit dem Thermoelement (4) und/oder die zweite Oberfläche (3) durch ein Grafit umfassendes Verbindungsteil (5) mit dem Thermoelement (4) thermisch verbunden wird.

11. Verfahren nach Anspruch 10, **dadurch gekennzeichnet, dass** Basalebenen des Grafits des Verbindungsteiles (5) entlang einer Geraden zwischen der ersten Oberfläche (2) und der zweiten Oberfläche (3) ausgerichtet werden.

12. Verfahren nach Anspruch 10 oder 11, **dadurch gekennzeichnet, dass** ein Verbindungsteil (5) bestehend aus expandiertem Grafit eingesetzt wird.

13. Verfahren nach einem der Ansprüche 10 bis 12, **dadurch gekennzeichnet, d**ass das Verbindungsteil (5) mit einem Rohr (11) oder dergleichen durch Pressen verbunden wird.

14. Verfahren zur Erzeugung elektrischer Energie durch einen Temperaturgradienten mit einer Vorrichtung (1), welche ein mit einer ersten Oberfläche (2) und einer zweiten Oberfläche (3) thermisch verbundenes Thermoelement (4) aufweist, insbesondere einer Vorrichtung (1) nach einem der Ansprüche 1 bis 9, wobei aufgrund einer Temperaturdifferenz eine Wärmemenge von der ersten Oberfläche (2) durch das Thermoelement (4) zur zweiten Oberfläche (3) übertragen wird, wodurch eine elektrische Spannung am Thermoelement (4) hervorgerufen wird, **dadurch gekennzeichnet, dass** die Wärmemenge zumindest teilweise von zumindest einem Grafit umfassenden Verbindungsteil (5) von der ersten Oberfläche (2) zum Thermoelement (4) und/oder vom Thermoelement (4) zur zweiten Oberfläche (3) übertragen wird.

15. Verfahren nach Anspruch 14, **dadurch gekennzeichnet, dass** die Wärmemenge entlang von Basalebenen im Verbindungsteil (5) übertragen wird, welche entlang einer Geraden zwischen der ersten Oberfläche (2) und der zweiten Oberfläche (3) ausgerichtet sind.

16. Verfahren nach Anspruch 14 oder 15, **dadurch gekennzeichnet, dass** die Wärmemenge von einem Rohr (11) auf die erste Oberfläche (2) übertragen wird und/oder die Wärmemenge von der zweiten Oberfläche (3) an einen Kühlkörper (13) übertragen wird.

17. Verfahren nach einem der Ansprüche 14 bis 16, **dadurch gekennzeichnet, dass** eine Temperaturdifferenz zwischen der ersten Oberfläche (2) und der zweiten Oberfläche (3) mittels einer Steuerung änderbar ist.
